# EUROPÄISCHE PATENTANMELDUNG

(11) **EP 2 717 021 A2**
(43) Veröffentlichungstag der Anmeldung: **09.04.2014**
(21) Anmeldenummer: 13185273.3
(22) Anmeldetag: 20.09.2013
(51) Int. Cl.: G01D 4/02, H04Q 9/00, G01R 22/06

(54) **Stromzählereinrichtung**

(30) Priorität: 05.10.2012 DE 102012109468
(71) Anmelder: Mangelberger, Jürgen, 91126 Schwabach (DE)
(72) Erfinder: Mangelberger, Jürgen, 91126 Schwabach (DE); Mangelberger, Oliver, 91126 Schwabach (DE)
(74) Vertreter: Simon, Josef

(57) **Zusammenfassung**

Stromzählereinrichtung (1), umfassend wenigstens eine Messeinrichtung (3, 4) die zum berührungslosen Erfassen physikalischer Größen eines durch eine Leitung (9) fließenden Stroms ausgebildet ist, wobei der Messeinrichtung (3, 4) ein Identifikationsmerkmal zugeordnet oder zuordenbar ist, und wobei die Messeinrichtung (3, 4) in einem, von mindestens einer Ausnehmung (21), durch die eine zu messende Leitung (9) führbar ist, durchsetzten, Gehäuse (22) angeordnet ist;
eine Zentraleinrichtung (2), die zum Auslesen der mindestens einen Messeinrichtung (3, 4) ausgebildet ist und einen Kommunikationsbaustein (12) umfasst;
mindestens einen Controller (10), der im Gehäuse (22) der wenigstens einen Messeinrichtung (3, 4) oder in der Zentraleinrichtung (2) angeordnet ist, zum Speichern und Verarbeiten der von der mindestens einen Messeinrichtung (3, 4) erfassten physikalischen Größen und des jeweiligen Identifikationsmerkmals, der zum Berechnen der verbrauchten Energie aus den physikalischen Größen ausgebildet ist;
wobei der Kommunikationsbaustein (12) zur Bereitstellung der von dem Controller (10) berechneten physikalischen Größen und des jeweils zugeordneten Identifikationsmerkmals über eine Kommunikationsschnittstelle als Ausgabedaten für eine Auswerteeinheit ausgebildet ist, wobei die wenigstens eine Messeinrichtung (3, 4) und die Zentraleinrichtung (2) als separate Module ausgebildet sind.

## Beschreibung

Die Erfindung betrifft eine Stromzählereinrichtung, umfassend wenigstens eine Messeinrichtung die zum berührungslosen Erfassen physikalischer Größen eines durch eine Leitung fließenden Stroms ausgebildet ist, wobei der Messeinrichtung ein Identifikationsmerkmal zugeordnet oder zuordenbar ist, und wobei die Messeinrichtung in einem, von mindestens einer Ausnehmung, durch die eine zu messende Leitung führbar ist, durchsetzten, Gehäuse angeordnet ist; eine Zentraleinrichtung, die zum Auslesen der mindestens einen Messeinrichtung ausgebildet ist und einen Kommunikationsbaustein umfasst; mindestens einen Controller, der im Gehäuse der wenigstens einen Messeinrichtung oder in der Zentraleinrichtung angeordnet ist, zum Speichern und Verarbeiten der von der mindestens einen Messeinrichtung erfassten physikalischen Größen und des jeweiligen Identifikationsmerkmals, der zum Berechnen der verbrauchten Energie aus den physikalischen Größen ausgebildet ist; wobei der Kommunikationsbaustein zur Bereitstellung der von dem Controller berechneten physikalischen Größen und des jeweils zugeordneten Identifikationsmerkmals über eine Kommunikationsschnittstelle als Ausgabedaten für eine Auswerteeinheit ausgebildet ist.

Zum Erfassen eines Stromverbrauchs werden Stromzähler eingesetzt, die häufig als Direktzähler oder Impulszähler ausgebildet sind. Ein solcher Zähler misst den verbrauchten Strom, beziehungsweise häufig auch die verbrauchte elektrische Leistung. Viele Stromzähleinrichtungen sind mit einer Anzeigevorrichtung ausgerüstet, um ein direktes Ablesen des verbrauchten Stroms zu ermöglichen. Daneben sind jedoch auch Stromzähler bekannt, die gemessene Energie oder Leistung über eine Leitungsverbindung an ein von dem Stromzähler entfernt angeordnetes Gerät übertragen können.

Während in Privathaushalten Stromzählereinrichtungen hauptsächlich zum Ermitteln der verbrauchten Energie eingesetzt werden, um eine Abrechnung zu ermöglichen, ist ein wichtiger Einsatzzweck von Stromzählereinrichtungen im gewerblichen Umfeld auch die Steigerung der Energieeffizienz und die Kostenersparnis. Es ist in diesem Fall wünschenswert, einzelne elektrische Verbraucher separat oder in Gruppen zu erfassen, um sie einer Kostenstelle zuordnen zu können. So kann beispielsweise der Stromverbrauch von Beleuchtung, Klimaanlage oder elektrisch angetriebenen Maschinen getrennt bestimmt werden. Nachteilig sind hier der große Platzbedarf herkömmlicher Stromzähler, sowie die Notwendigkeit, diese einzeln abzulesen. Zudem sind für diese Stromzähler zusätzliche Kontakte notwendig, die eine zusätzliche Fehlerquelle darstellen. Auch ist die maximal messbare Stromstärke von Direktzählern begrenzt.

Aus der DE 10 2009 024 301 A1 ist ein Mehrfachstromzählermodul bekannt, das viele der beschriebenen Nachteile beseitigt. Hier findet die Strommessung kontaktfrei statt, indem die zu messenden Leitungen durch Ausnehmungen des Gehäuses des Geräts geführt werden. Es kann Leistung, Strom und Phase ermittelt werden, die Daten können gespeichert und zur Auswertung an eine externe Auswerteeinheit weitergegeben werden. Zur Weitergabe der Daten steht hier eine Vielzahl von Protokollen zu Verfügung. Zum Einsatz dieses Moduls ist jedoch ein relativ großer Bereich einer Verteileranlage notwendig. Dies ist bei der Konzeption neuer Verteileranlagen leicht zu berücksichtigen, insbesondere bei der Nachrüstung älterer, teilweise eng bestückter, Anlagen ist ein Einsatz dieser Module jedoch häufig nicht auf einfache Weise möglich.

Der Erfindung liegt daher die Aufgabe zugrunde, eine Stromzählereinrichtung anzugeben, die eine einfachere und platzsparendere Integration in einen Schaltschrank ermöglicht.

Zur Lösung dieser Aufgabe ist bei einer Stromzählereinrichtung der eingangs genannten Art erfindungsgemäß vorgesehen, dass die wenigstens eine Messeinrichtung und die Zentraleinrichtung als separate Module ausgebildet sind.

Da eine kompakte Bauform der Messeinrichtung gewünscht ist, ist deren Komplexität begrenzt. Daher umfasst die Stromzählereinrichtung erfindungsgemäß zusätzlich eine Zentraleinrichtung. Diese Zentraleinrichtung ist für die Kommunikation mit einer Vielzahl von Messeinrichtungen ausgebildet, wobei die Kommunikation vorzugsweise über einen seriellen Bus und nicht über einzeln zu verlegende Leitungen zwischen Stromzählereinrichtung und Zentraleinrichtung stattfindet. Da jede Messeinrichtung ein individuelles Identifikationsmerkmal hat, kann jede Messeinrichtung auch dann individuell angesprochen und ihre Messdaten analysiert werden, wenn mehrere Messeinrichtungen über einen Bus ausgelesen beziehungsweise angesteuert werden. Im Falle des Betriebs über einen digitalen, insbesondere einen seriellen Bus ist ein besonders einfacher Anschluss möglich, da eine Vielzahl von Messeinrichtungen mit einem einzigen Kabel mit der Zentraleinrichtung verbunden werden können. Es ist auch möglich, die Messeinrichtungen mit diesem Kabel mit Strom zu versorgen.

Dabei kann das Gehäuse der Messeinrichtung eine Vorrichtung zur lösbaren Befestigung an einem Schaltglied aufweisen. Es wird also vorteilhaft ausgenutzt, dass die Stromleitungen ohnehin zu Schaltgliedern, insbesondere Leistungsschutzschaltern in Schaltschränken geführt werden. Das Schaltglied kann irgendein Schalter, jedoch insbesondere ein Leistungsschutzschalter, ein Relais oder ein Schütz sein. Oberhalb oder unterhalb dieser Schaltglieder ist normalerweise ein Freiraum vorhanden, in den eine Messeinrichtung eingebracht werden kann. Die Erfindung sieht eine kompakte Messeinrichtung vor, die an einem vorhandenen Schaltglied anbringbar ist. Die Messung erfolgt kontaktfrei. Damit ist zum einen eine Messung größerer Ströme beziehungsweise Wirk-, Schein- oder Blindleistungen möglich, zum anderen werden zusätzliche Fehlerquellen durch zusätzliche Kontakte ausgeschlossen.

Die Verwendung von getrennten Messeinrichtungen und einer Zentraleinrichtung bietet wegen der besseren Anbringbarkeit in einer Verteileranlage zudem weitere Vorteile. So kann sehr einfach eine zusätzliche Messeinrichtung hinzugefügt werden. Zur Installation einer zusätzlichen Messeinrichtung muss lediglich die Leitung, die gemessen werden soll, durch die Messeinrichtung geführt werden, diese auf das Schaltglied aufgesteckt werden, sowie die Messeinrichtung mit einem der Kabel, die zur Zentraleinheit führen, verbunden werden. Ein weiterer Vorteil ist, dass zum Einbau oder Wechsel der Messeinrichtungen jeweils nur das Kabel abgeklemmt werden muss, an dem gerade eine Messeinrichtung angebracht wird.

Durch das Anbringen der Messeinrichtungen am Schaltglied kann zudem die Verkabelung bei Nachrüstung einer Verteileranlage unverändert bleiben. Würden andere, größere Stromzählereinrichtungen genutzt werden, so müssten die Kabel zusätzlich durch diese an anderer Stelle angebrachten Stromzählereinrichtungen geführt werden.

Die Messeinrichtungen können vor allem als einphasige Messeinrichtungen mit einer Ausnehmung am Gehäuse, als zweiphasige Messeinrichtungen mit zwei Ausnehmungen am Gehäuse oder als dreiphasige Messeinrichtung mit drei Ausnehmungen am Gehäuse ausgebildet sein. Selbstverständlich ist es auch möglich an zwei- oder dreiphasigen Stromversorgungen eine einzelne Messeinrichtung für jede Phase vorzusehen. Diese Ausbildungen entsprechen insbesondere den üblichen Abmessungen von Leistungsschutzschaltern.

Da eine Zentraleinrichtung verwendet wird, bleiben trotz Verwendung dezentraler Messeinrichtungen die Vorteile einer zentralen Datenerfassung und der zentralen Datenhaltung erhalten. So kann aus der Zentraleinrichtung, die als ein einzelnes Gerät durch eine Vielzahl von Protokollen ansprechbar ist, schnell eine Übersicht über die Verbrauchsdaten einer Vielzahl von Geräten ausgelesen werden. Zur Erfassung der einzelnen physikalischen Größen sowie des Energieverbrauchs ist ein Controller vorgesehen. Dieser kann entweder in den einzelnen Messeinrichtungen angeordnet sein oder in der Zentraleinrichtung. Mit Hilfe dieses Controllers ist es auch möglich, die physikalischen Größen und den Energieverbrauch in regelmäßigen Zeitabständen aufzunehmen und damit einen Zeitverlauf des Energieverbrauchs beziehungsweise anderer physikalische Größen zu erhalten. Ein solcher zeitlicher Verlauf des Energieverbrauchs ermöglicht es beispielsweise, Spitzen des Leistungsverbrauchs festzustellen, und bei Bedarf die Steuerung der Verbraucher anzupassen, um diese Spitzen zu vermeiden. Es kann auch festgestellt werden, ob Spitzen des Stromverbrauchs in Zeiten liegen, in denen Strom besonders günstig oder besonders teuer ist. Auch hilft eine zeitliche Auftragung Sparpotentiale zu erkennen. So kann bei Energieverbrauch außerhalb der Geschäftszeiten beispielsweise festgestellt werden, ob es sich bei den Energie verbrauchenden Geräten um Geräte handelt, die auch nachts laufen müssen, oder ob es sich beispielsweise um Beleuchtung handelt.

Der Kommunikationsbaustein der Zentraleinrichtung erlaubt einen Zugriff auf die gesammelten Daten über eine Vielzahl von Kommunikationsprotokollen. Damit ist eine leichte Integration in eine bestehende Mess- und Regelarchitektur möglich. Als Auswerteeinheit kann auch ein normaler Computer oder aber ein Smartphone/Tablet-PC dienen. Dieser kann beispielsweise über ein LAN, ein WLAN oder Bluetooth mit der Zentraleinrichtung verbunden sein, es ist aber auch ein bidirektionaler Zugang über das Internet, insbesondere durch Virtual Private Networks möglich. Es ist möglich, dass eine Auswerteeinheit stetig Daten von der Zentraleinheit abholt, die Daten können aber auch auf der Zentraleinheit gespeichert und nur bei Bedarf ausgelesen werden.

Zur einfachen Verdrahtung sowie zur Minimierung der Fehlerwahrscheinlichkeit bietet die lösbare Befestigung der Messeinrichtung an einem Schaltglied viele Vorteile. Diese kann als Rast- oder Klemmverbindung zur Befestigung an der Ober- oder Unterseite des Schaltglieds, das insbesondere als Leistungsschutzschalter, Relais oder Schütze ausgebildet sein kann, ausgebildet sein. Damit ist ein besonders einfaches und schnelles Anbringen der Messeinrichtung durch Aufstecken möglich. Eine Rast- oder Klemmverbindung bietet zuverlässigen Halt und durch die Befestigung der Messeinrichtung am Schaltglied wird eine zusätzliche Belastung des Kabels vermieden. Eine derartige feste Anbringung erleichtert zudem die zentrale Führung der zu messenden Leitung in der Ausnehmung.

Zur Befestigung der Messeinrichtung an eine Vielzahl unterschiedlicher Schaltglieder verschiedener Hersteller ist es vorteilhaft, wenn die Rastverbindung mindestens zwei gegenüberliegend am Gehäuse der Messeinrichtung angeformte Rastnasen und/oder Rastlaschen aufweist, vorzugsweise jeweils eine Rastnase und eine Rastlasche an gegenüberliegenden Seiten des Gehäuses, wobei die Rastnasen beziehungsweise Rastlaschen derart angeordnet sind, dass die Rastnasen zum Eingreifen in am Schaltglied vorhandene Vertiefungen und die Rastlaschen zur Aufnahme von am Schaltglied vorhandenen Vorsprüngen ausgebildet sind.

Eine kontaktfreie Messung des Stroms, der durch eine Leitung fließt, ist insbesondere durch eine Messung des die Leitung umgebenden Magnetfelds möglich. Es ist insbesondere möglich, dass die wenigstens eine Messeinrichtung wenigstens eine Rogowski-Spule, die um die wenigstens eine das Gehäuse durchsetzende Ausnehmung herum angeordnet ist, durch die eine Leitung führbar ist und/oder wenigstens eine Hallsonde aufweist. Hallsonden können sowohl zur Messung statischer als auch zur Messung dynamischer Magnetfelder genutzt werden. Sollen also mit der Stromzähleinrichtung Gleichströme gemessen werden, so ist die Verwendung von Hallsonden vorteilhaft. In Hallsonden wird eine Verschiebespannung aufgrund eines Stroms, der durch die Hallsonde geschickt wird, und der senkrechten Komponenten des die Hallsonde durchsetzenden Magnetfelds gemessen. Zum Erreichen einer optimalen Messgenauigkeit sollten die Hallsonden also so angeordnet sein, dass sie senkrecht zum Magnetfeld stehen. Bei optimaler Anordnung liegt der Leiter in der Ebene, auf der auch die Hallsonde liegt. Da das Magnetfeld des Leiters stark abstandsabhängig ist, ist es vorteilhaft, wenn eine Vielzahl von Hallsonden symmetrisch um die Aufnehmung im Gehäuse angeordnet ist.

Soll ein Wechselstrom gemessen werden, kann die Verwendung einer Rogowski-Spule vorteilhaft sein. Eine Rogowski-Spule ist eine toroidförmige Spule ohne ferromagnetischen Kern. Fließt ein Wechselstrom durch den Leiter, so ist dieser von einem magnetischen Wechselfeld umgeben. Damit ändert sich der Fluss durch die Spule, wodurch eine Spannung induziert wird. Das Integral dieser Spannung ist zum Leiterstrom proportional. Um eine Abhängigkeit der Strommessung von der Lage des Leiters innerhalb der Ausnehmung des Gerätes zu vermeiden ist es möglich, eine Rogowski-Spule ohne einen Luftspalt zu verwenden. Zur Berechnung der verbrauchten Energie ist vorteilhaft, dass die wenigstens eine Messeinrichtung zum Erfassen des Stroms und gegebenenfalls des Phasenwinkels als physikalische Größen ausgebildet ist. In diesem Fall kann die Spannung sowie die Phase des Spannungsverlaufs voreingestellt werden. Damit kann aus Spannung und Strom leicht die Leistung berechnet werden, und durch Integrieren ebenfalls die verbrauchte Energie. Die Berücksichtigung der Phase erlaubt es zwischen Wirk- und Blindleistung zu unterscheiden. Da bei gewerblichen Verbrauchern auch Kosten für die Nutzung von Blindleistung anfallen können, aus dieser jedoch kein Nutzwert entsteht, kann die Stromzählereinrichtung somit genutzt werden, um die Blindleistung zu verringern und damit Kosten zu sparen.

Die wenigstens eine Messeinrichtung kann auch zum Erfassen der physikalischen Größen in festgelegten oder festlegbaren Zeitintervallen ausgebildet sein. Damit können Informationen über den zeitlichen Verlauf des Gesamtverbrauchs sowie den Verbrauch von Einzelgeräten beziehungsweise Gerätegruppen gewonnen werden, ohne dass stets durch eine Auswerteeinrichtung auf die Stromzählereinrichtung zugegriffen werden muss. So kann durchgehend der zeitlich aufgelöste Energieverbrauch aufgezeichnet, und bei Bedarf überprüft werden. Die Auswerteeinrichtung kann hierfür eine Vielzahl von Auswertemöglichkeiten bereitstellen. So kann schnell festgestellt werden, wann, wie häufig und wie lange welche Geräte beziehungsweise Gerätegruppen genutzt werden. Zudem können unnötige Verbraucher leichter erkannt werden. Ein solcher zeitlicher Verlauf des Energieverbrauchs kann auch genutzt werden, um Leistungsspitzen zu vermeiden, indem beispielsweise Nutzungszeiten von Geräten abgestimmt werden. Zudem kann versucht werden, Leistungsspitzen in Zeitfenster zu verschieben, in denen günstigerer Strombezug möglich ist.

Zur besonders einfachen Integration in vorhandene Schaltschränke ist es vorteilhaft, wenn die Messeinrichtung zum Einbau zwischen Reihen von Schaltgliedern in Schaltschränken ausgebildet ist und eine Höhe von maximal 30 mm, vorzugsweise maximal 15 mm sowie eine Breite von weniger als 18 mm pro Ausnehmung, durch die eine Leitung führbar ist, aufweist. In diesem Fall können handelsübliche Schaltschränke genutzt werden. Dies ist vor allem für Nachrüstungen bereits existierender Verteileranlagen wichtig. Jedoch ist auch beim Neuaufbau von Verteileranlagen ein sauberer Aufbau in Verteilungsschränken bei maximaler Nutzung des vorhandenen Raums vorteilhaft.

Es existiert eine Vielzahl von Schaltgliedern verschiedener Hersteller. In vielen Fällen sind diese Schaltglieder leicht unterschiedlich aufgebaut. Damit ist es vorteilhaft, wenn zumindest Teile der Rast- oder Klemmverbindungen der Messeinrichtung eine Sollbruchstelle aufweisen.

Die Zentraleinrichtung kann zur digitalen Ansteuerung und zum digitalen Auslesen der mindestens einen Messeinrichtung ausgebildet sein, vorzugsweise über einen M-Bus, XML, TCP/IP, LAN oder einen Modbus. Die Kommunikation über einen digitalen Bus erlaubt es, eine Vielzahl von Messeinrichtungen über nur eine Busleitung zu betreiben. Bei den erfindungsgemäßen Stromzählereinrichtungen ist es auch wichtig, dass ein bewährtes und zuverlässiges Kommunikationsinterface genutzt wird. Hier haben sich M-Bus, Modbus, TCP/IP, LAN und XML bewährt. Ein weiterer Vorteil der Verwendung eines Standardbusses ist es, dass Komponenten, die eine Kommunikation auf diesen Bus ermöglichen, leicht verfügbar sind. Es ist jedoch selbstverständlich auch möglich, beliebige andere digitale kabelgebundene oder kabellose Protokolle wie z. B. LON zu verwenden. Auch eine analoge Ansteuerung ist möglich.

Bei der erfindungsgemäßen Stromzählereinrichtung kann eine Vielzahl von Messeinrichtungen genutzt werden. Um eine klare Zuordnung der einzelnen Messeinrichtungen zu Verbrauchern oder Verbrauchergruppen zu gewährleisten, ist es vorteilhaft, wenn für jede zu messende Leitung eine Zuordnung der gemessenen Leitung zu einer Gruppe und/oder eine Phasenlage entweder an der zugeordneten Messeinrichtung und/oder durch die Steuereinrichtung einstellbar ist. Gegenüber fest vergebenen Zuordnungen haben einstellbare Zuordnungen zwei wesentliche Vorteile. Zum einen können, besonders bei großen Installationen, zunächst alle Messmodule in beliebiger Reihenfolge verbaut werden, wobei die Zuordnung anschließend erfolgen kann. Zum anderen ist es auch möglich, die Zuordnung mit einem Bezeichner zu versehen. Damit ist auch in dem Fall, in dem die Zentraleinrichtung oder die Auswerteeinrichtung gewechselt werden, weiterhin eine klare Zuordnung einzelner Verbraucher oder Verbrauchergruppen möglich. Einstellbare Phasen der Messeinrichtungen ermöglichen den Betrieb von baugleichen Messeinrichtungen für mehrere Phasen bei einer dreiphasigen Strommessung und ebenfalls die Strommessung in zweiphasigen Netzen. Damit wird herstellerseitig die Anzahl der verschiedenen Messeinrichtungen reduziert und kundenseitig entsteht der Vorteil, dass die Messeinrichtungen vielseitiger verwendbar sind.

Die Zentraleinrichtung kann zudem eine Schnittstelle zur Verbindung mit weiteren Zentraleinrichtungen weiterer Stromzählereinrichtungen aufweisen. Damit kann über einen Kommunikationsbaustein der Zugriff auf mehr Messeinrichtungen ermöglicht werden, als an einer Zentraleinheit angeschlossen werden können. Damit ist es möglich, weitere Infrastrukturen wie Router oder Ähnliches zu sparen.

Ein wesentlicher Bestandteil der erfindungsgemäßen Stromzählereinrichtung ist die Kommunikation mit der Auswerteeinheit. Um eine möglichst flexible Integration in eine bestehende Infrastruktur zu ermöglichen, kann der Kommunikationsbaustein mindesten eine Schnittstelle aus der Gruppe M-Bus, Modbus, USB und Ethernet zum Anschluss der Auswerteeinheit aufweisen und/oder zur Drahtloskommunikation mit der Auswerteeinheit über WLAN und/oder Bluetooth ausgebildet sein. Damit ist die Nutzung verschiedener Auswerteeinheiten möglich. So kann beispielsweise ein Servicetechniker vor Ort die Stromzählereinrichtung mit einem mobilen Auswertegerät, das über Bluetooth kommuniziert, auslesen. Gleichzeitig kann es aber auch möglich sein, dass die Stromzählereinrichtung weiterhin fest mit dem Firmennetz verbunden ist. Damit entstehen für weitere Nutzer keine Einschränkungen der Nutzung, während lokal die Nutzung eines mobilen Auslesegerätes möglich ist. Die Vielzahl der möglichen Schnittstellen beziehungsweise drahtlosen Kommunikationsmöglichkeiten erlaubt auch eine flexible Integration in bestehende Kommunikationsinfrastruktur. So kann beispielsweise ein Fehlen einer drahtgebundenen Kommunikationsverbindung am Messort leicht durch die Verwendung einer WLAN-Verbindung ausgeglichen werden. Andererseits kann die Zentraleinrichtung auch an bestehende M-Bus-oder Modbus-Verbindungen angebunden werden. Gerade auch im Wartungsbereich kann es vorteilhaft sein, die Zentraleinrichtung über USB anzusprechen. Selbstverständlich sind auch eine Vielzahl anderer Nutzungen dieser Protokolle denkbar.

Eine besonders flexible Nutzung der erfindungsgemäßen Stromzählereinrichtung ist möglich, wenn der Kommunikationsbaustein einen Webserver aufweist, um die Ausgabedaten der Auswerteeinheit zur Verfügung zu stellen. Damit kann beispielsweise ein weltweiter Zugriff auf die Daten über das Internet möglich sein, insbesondere geschützt innerhalb eines Virtual Privat Networks. Auch die Bedienführung kann hier sehr einfach gestaltet werden, da eine Internetseite als Benutzerinterface genutzt werden kann und der Benutzer damit keine neuen gerätespezifischen Bedienmuster erlernen muss. Andererseits ist es jedoch auch möglich, dass der Webserver mit einem weiteren Webserver kommuniziert, der Daten einer Vielzahl von Stromzählereinrichtungen sammelt und auswertet. Damit kann es beispielsweise möglich sein, über eine einzelne Internetseite Zugriff auf alle Stromzählereinrichtungen eines weltweit agierenden Unternehmens zu geben. Selbstverständlich ist hier auch eine Differenzierung von Zugriffsrechten möglich. Selbstverständlich ist auch die Nutzung von anderen Internetprotokollen möglich. So können beispielsweise in regelmäßigen Abständen e-Mails mit zusammengefasster Information verschickt werden oder Ähnliches.

Hier ist es besonders vorteilhaft, wenn der Webserver mit der Auswerteeinheit über ein Modem, ein DSL-Modem, ein GSM-Modem, ein UMTS-Modem oder via LAN verbindbar oder verbunden ist.

Insbesondere kann das Schaltglied ein Leistungsschutzschalter, ein Relais oder ein Schütz sein.

Bei der erfindungsgemäßen Stromzählereinrichtung ist es nicht notwendig, die Messeinrichtungen fest an bestimmten Stellen anzuordnen, sondern sie können an jedem Punkt des zu messenden Kabels angeordnet sein. Insbesondere um dennoch in Bereichen mit einer Vielzahl von Kabeln einen geordneten Aufbau der Stromzählereinrichtung zu erreichen, ist es möglich, dass das Gehäuse der Messeinrichtung auf wenigstens einer Seite, vorzugsweise auf zwei insbesondere gegenüberliegenden Seiten, des Gehäuses jeweils ein Kopplungselement zum formschlüssigen Koppeln der Messeinrichtung mit einer weiteren Messeinrichtung aufweist. Dabei kann das erste der Kopplungselemente eine gegengleich zur Form des zweiten Kopplungselements ausgebildete From aufweisen. Durch die Kopplungselemente ist es möglich, dass mehrere Messeinrichtungen durch einfaches Stecken miteinander verbunden werden können, um größere Blöcke aus mehreren Messeinrichtungen zu bilden.

Weitere Vorteile und Einzelheiten der Erfindung ergeben sich aus dem im Folgenden beschriebenen Ausführungsbeispiel sowie anhand der Zeichnungen. Dabei zeigen:
- Fig. 1: eine schematische Übersicht über eine erfindungsgemäße Stromzählereinrichtung mit angeschlossener Auswerteeinheit,
- Fig. 2: eine geschnittene Ansicht eines Ausführungsbeispiels der Messeinrichtung einer erfindungsgemäßen Stromzählereinrichtung,
- Fig. 3: das Gehäuse der Messeinrichtung von Fig. 2 von unten,
- Fig. 4: eine Seitenansicht der Messeinrichtung von Fig. 2 sowie eines Leistungsschutzschalters, die die Elemente der Rastverbindung zeigt,
- Fig. 5: eine Vorderansicht der Messeinrichtung von Fig. 2,
- Fig. 6: eine perspektivische Ansicht eines sechsten Ausführungsbeispiels der Messeinrichtung einer erfindungsgemäßen Stromzählereinrichtung,
- Fig. 7: eine Anordnung aus mehreren der in Fig. 9 gezeigten Messeinrichtungen, und

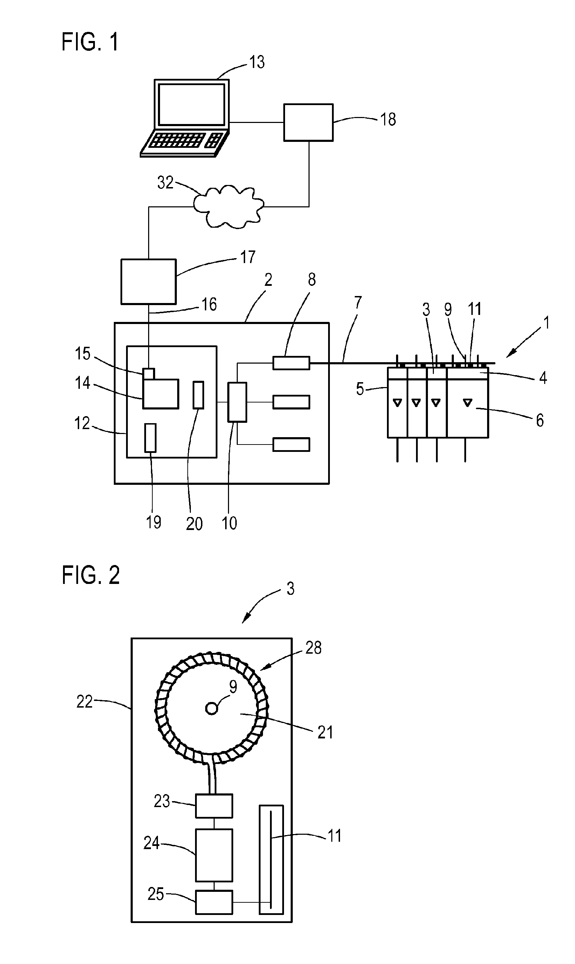

Fig. 1 zeigt eine schematische Übersicht der Stromzählereinrichtung 1 mit angeschlossener Auswerteeinheit. Die Stromzählereinrichtung 1 umfasst eine Zentraleinrichtung 2 sowie mehrere Messeinrichtungen 3, 4. Die Messeinrichtungen 3, 4 sind auf Leistungsschutzschaltern 5, 6 angeordnet und über ein Flachbandkabel 7 mit einem Anschluss 8 der Zentraleinrichtung 2 verbunden. Die Zentraleinrichtung 2 der Stromzählereinrichtung 1 ist über das Internet 9 mit der Auswerteeinheit 13 verbunden.

Der Energieverbrauch wird sowohl an einphasigen Leistungsschutzschaltern 5 als auch an einem dreiphasigen Leistungsschutzschalter 6 gemessen. Auf den einphasigen Leistungsschutzschaltern 5 sind Messeinrichtungen 3 mit einer Ausnehmung angeordnet, auf dem dreiphasigen Leistungsschutzschalter 6 Messeinrichtungen 4 drei Ausnehmungen. In beiden Fällen sind die Leitungen oben und unten am Leistungsschutzschalter 5, 6 angeschlossen und am oberen Teil des Leistungsschutzschalters 5, 6 durch Ausnehmungen der Messeinrichtungen 3, 4 geführt. Die Messeinrichtungen 3, 4 sind dazu ausgebildet, in einem festen zeitlichen Abstand Stromstärke und -phase zu messen. Zudem ist jeder der Messeinrichtungen 3, 4 ein Identifikationsmerkmal, das die Messeinrichtung einem Verbraucher oder einer Verbrauchergruppe zuordnet, sowie eine Phasenlage der Spannung zugeordnet. Die Verbindung zwischen Messeinrichtungen 3, 4 und Zentraleinrichtung 2 erfolgt über einen Modbus. Die einzelnen Messeinrichtungen 3, 4 sind über Anschlüsse 11 mit einem Flachbandkabel 7 mit dem Anschluss 8 der Zentraleinrichtung verbunden. Die dreiphasig ausgebildete Messeinrichtung 4 weist hierbei minimal einen bis maximal drei Anschlüsse 11 auf. Über diese Verbindung kommuniziert der in der Zentraleinrichtung 2 angeordnete Controller 10 mit den einzelnen Messeinrichtungen 3, 4 und kann die Werte der Stromstärke und der Phase aufnehmen. Im Controller 10 wird mit der bekannten Spannung und der den Messeinrichtungen 3, 4 zugeordneten jeweiligen Phase die Wirk- und Blindleistung berechnet. Zudem wird durch Integration über ein einstellbares Zeitfenster zeitlich aufgelöst der Energieverbrauch berechnet. Der Controller 10 ist mit einem Kommunikationsbaustein 12 verbunden. Der Kommunikationsbaustein 12 stellt eine Vielzahl an Verbindungsmöglichkeiten zur Verfügung. Die Kommunikation mit der Auswerteeinheit 13 erfolgt über einen in den Kommunikationsbaustein 12 integrierten Webserver 14. Der Webserver 14 ist über einen in den Kommunikationsbaustein 12 integrierten Ethernetanschluss 15 und einem Ethernetkabel 16 mit einem DSL-Modem 17 verbunden. Dieses kommuniziert über das Internet 32 mit einem weiteren DSL-Modem 18, das wiederum über Ethernet mit der Auswerteeinheit 13 verbunden ist. Die Kommunikation über das Internet kann herkömmlich oder geschützt durch ein Virtual Privat Network erfolgen.

Die Zentraleinrichtung 2 weist zudem eine Vielzahl weiterer Anschlüsse 19 auf. Diese erlauben zum einen die Verbindungen mit weiteren Zentraleinheiten, um mehrere Stromzählereinrichtungen zu verbinden, zum anderen den Anschluss weiterer Auswerteeinheiten über USB, M-Bus, TCP/IP, LAN und Modbus. Zur Anbindung an andere Kommunikationsinfrastrukturen, beziehungsweise Wartungszwecken stehen auch Einrichtungen zur drahtlosen Kommunikation 20 zur Verfügung. Hierüber ist eine Kommunikation mit Mobilfunkgeräten über GSM oder UMTS sowie eine Anbindung über WLAN möglich.

Fig. 2 zeigt eine geschnittene Ansicht der Messeinrichtung 3 der Stromzählereinrichtung 1. Die Leitung 9 ist durch eine Ausnehmung 21 des Gehäuses 22 geführt. Um die Ausnehmung 21 ist eine Rogowski-Spule 28 angeordnet. Durch das magnetische Wechselfeld der Leitung 9, die Wechselstrom führt, wird in der Rogowski-Spule 28 eine Wechselspannung induziert. Durch Integration der induzierten Spannung in der Ausleseelektronik 23 kann eine Größe bestimmt werden, die proportional zur Stromstärke ist. Zudem kann die Phase des Stroms ermittelt werden. Die in der Ausleseelektronik 23 ermittelten Messwerte werden von einer Datenverarbeitungseinrichtung 24 gespeichert und verarbeitet. Damit ist insbesondere eine Pufferung der Messwerte möglich, bis sie an die Zentraleinrichtung 2 übertragen werden. Auch können somit Daten in festen Zeitintervallen aufgenommen werden, ohne dass Steuersignale von der Zentraleinrichtung 2 an die Messeinrichtung 3 übertragen werden müssen. Die Kommunikation mit der Zentraleinrichtung 2 erfolgt über einen Modbus-Anschluss 11, der über einen Schnittstellentreiber 25 angebunden ist. Die Stromversorgung der Messeinrichtung 3 erfolgt ebenfalls über den Anschluss 11.

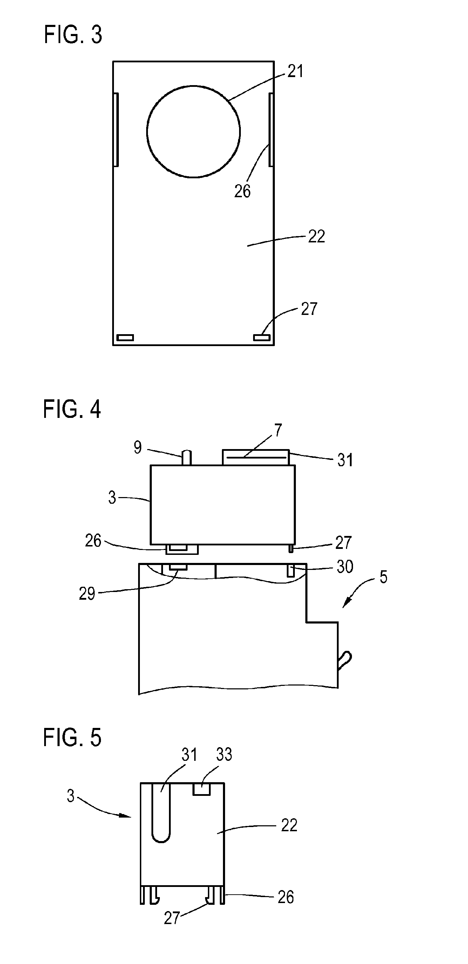

Fig. 3 zeigt das Gehäuse der Messeinrichtung der Stromzählereinrichtung von unten. Neben der Ausnehmung 21 sind hier die am Gehäuse 22 angeordneten Elemente 26, 27 der Rastverbindung zu sehen. Die Rastverbindung erfolgt über zwei Rastlaschen 26 und zwei Rastnasen 27. Diese sind jeweils an gegenüberliegenden Seiten des Gehäuses angeordnet.

Fig. 4 zeigt eine Seitenansicht der Messeinrichtung und eines Leistungsschutzschalters, die die Elemente der Rastverbindung zeigt. Die Messeinrichtung 3 kann auf den Leistungsschutzschalter 5 aufgesetzt, und dort eingerastet werden. Dabei rasten zwei an der Messeinrichtung 3 angeordnete Rastlaschen 26 an zwei am Leistungsschutzschalter angeordneten Vorsprüngen 29 ein sowie zwei an der Messeinrichtung 3 angeordnete Rastnasen 27 in Vertiefungen 30 am Leistungsschutzschalter 5. Damit wird ein fester Sitz der Messeinrichtung 3 am Leistungsschutzschalter 5 erreicht. Die Installation an der Messeinrichtung 3 erfolgt, indem die Leitung 9 durch die Ausnehmung 21 der Messeinrichtung 3 geführt wird, und dann mit dem Leistungsschutzschalter 5 verbunden wird. Anschließend wird die Messeinrichtung 3 auf den Leistungsschutzschalter 5 aufgesteckt. Die Verbindung zur Zentraleinrichtung 2 erfolgt dann über ein Flachbandkabel 7. Auf dieses ist ein Stecker aufgesetzt, der mit dem Anschluss 11 der Messeinrichtung 3 verbunden wird.

Fig. 5 zeigt eine Vorderansicht der Messeinrichtung 3 von Fig. 2. Am Gehäuse 22 der Messeinrichtung 3 sind zwei Rastnasen 27 und zwei Rastlaschen 26 zur Befestigung an einem Leistungsschutzschalter angeformt. An der Frontseite des Gehäuses 22 befindet sich eine Zunge 31, die lediglich an ihrem (in Fig. 5 oberen) Ende mit dem Gehäuse 22 verbunden ist. Das gegenüberliegende zungenförmige Ende kann durch eine senkrecht zur Zeichnungsebene wirkende Kraft in das Gehäuse 22 gedrückt werden, um einen hinter der Zunge 31 im Inneren des Gehäuses 22 angeordneten Schalter (nicht gezeigt) zu betätigen. Durch Betätigen des Schalters ist eine Einstellung der Gruppenzuordnung möglich und es ist möglich, das Identifikationsmerkmal und die Phasenlage für die Messeinrichtung 3 anzupassen. Hierzu sind jeweils Betätigungsmuster vorgegeben.

Zusätzlich ist an der Messeinrichtung 3 eine RGB-Leuchtdiode 33 vorgesehen. Die RGB-Leuchtdiode wird durch die Datenverarbeitungseinrichtung der Messeinrichtung 3 angesteuert und zeigt durch Helligkeits- und/oder Farbwechsel Funktionen und Zustände der Messeinrichtung 3 an.

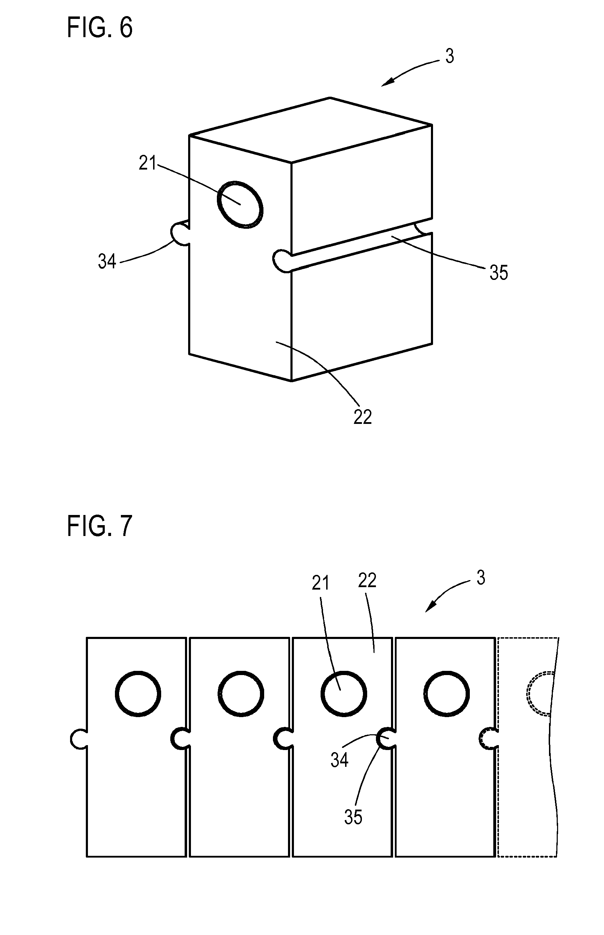

Fig. 6 und Fig. 7 zeigen ein Ausführungsbeispiel, um Messeinrichtungen der Stromzählereinrichtung auch dann geordnet an einem Leitungsstrang anzuschließen, wenn die einzelnen Messeinrichtungen ausschließlich an den Leitungen befestigt sind. Hierzu sind an der in Fig. 6 gezeigten Messeinrichtung 3 an zwei gegenüberliegenden Seiten des Gehäuses 22 der Messeinrichtung 3, die nicht von der Ausnehmung 21 durchsetzt sind, Kopplungselemente 34, 35 ausgebildet, die eine Kopplung der Messeinrichtung 3 mit weiteren Messeinrichtungen erlauben. Mittels dieser Kopplungselemente können mehrere Messeinrichtungen zusammengefügt werden, um die einzelnen Phasen einer mehrphasigen Stromversorgung zu messen oder auch um eine Vielzahl von Leitungen in einer geordneten Anordnung zu messen. Das Kopplungselement 34 bildet dabei einen Vorsprung, der in die durch das Kopplungselement 35 einer weiteren Messeinrichtung gebildete Ausnehmung eingreifen kann. Die Kopplungselemente 34 und 35 sind derart geformt, dass ein Einführen des vorstehenden Kopplungselements 34 in die Ausnehmung, die durch das Kopplungselement 35 gebildet wird, in Richtung der Ausnehmung möglich ist. Die einzelnen Messeinrichtungen können zusammengesteckt werden und sind anschließend reib- und formschlüssig miteinander verbunden.

Fig. 7 zeigt eine Anordnung mehrerer der in Fig. 6 gezeigten Messeinrichtungen 3, wodurch ein kompakter Block gebildet wird.

## Patentansprüche

1. Stromzählereinrichtung (1), umfassend wenigstens eine Messeinrichtung (3, 4) die zum berührungslosen Erfassen physikalischer Größen eines durch eine Leitung (9) fließenden Stroms ausgebildet ist, wobei der Messeinrichtung (3, 4) ein Identifikationsmerkmal zugeordnet oder zuordenbar ist, und wobei die Messeinrichtung (3, 4) in einem, von mindestens einer Ausnehmung (21), durch die eine zu messende Leitung (9) führbar ist, durchsetzten, Gehäuse (22) angeordnet ist;
eine Zentraleinrichtung (2), die zum Auslesen der mindestens einen Messeinrichtung (3, 4) ausgebildet ist und einen Kommunikationsbaustein (12) umfasst;
mindestens einen Controller (10), der im Gehäuse (22) der wenigstens einen Messeinrichtung (3, 4) oder in der Zentraleinrichtung (2) angeordnet ist, zum Speichern und Verarbeiten der von der mindestens einen Messeinrichtung (3, 4) erfassten physikalischen Größen und des jeweiligen Identifikationsmerkmals, der zum Berechnen der verbrauchten Energie aus den physikalischen Größen ausgebildet ist;
wobei der Kommunikationsbaustein (12) zur Bereitstellung der von dem Controller (10) berechneten physikalischen Größen und des jeweils zugeordneten Identifikationsmerkmals über eine Kommunikationsschnittstelle als Ausgabedaten für eine Auswerteeinheit ausgebildet ist,
**dadurch gekennzeichnet, dass** die wenigstens eine Messeinrichtung (3, 4) und die Zentraleinrichtung (2) als separate Module ausgebildet sind.

2. Stromzählereinrichtung nach Anspruch 1, **dadurch gekennzeichnet, dass** das Gehäuse (22) der Messeinrichtung (3, 4) eine Vorrichtung (26, 27) zur lösbaren Befestigung an einem Schaltglied (5, 6) aufweist.

3. Stromzählereinrichtung nach Anspruch 2, **dadurch gekennzeichnet, dass** das Schaltglied ein Leistungsschutzschalter, ein Relais oder ein Schütz ist.

4. Stromzählereinrichtung nach Anspruch 2 oder 3, **dadurch gekennzeichnet, dass** die Vorrichtung (26, 27) zur lösbaren Befestigung als Rast- oder Klemmverbindung zur Befestigung an der Ober- oder Unterseite des Schaltglieds (5, 6) ausgebildet ist.

5. Stromzählereinrichtung nach Anspruch 4, **dadurch gekennzeichnet, dass** die Rastverbindung mindestens zwei gegenüberliegend am Gehäuse der Messeinrichtung angeformte Rastnasen (27) und/oder Rastlaschen (26) aufweist, vorzugsweise jeweils eine Rastnase (27) und eine Rastlasche (26) an gegenüberliegenden Seiten des Gehäuses (22), wobei die Rastnasen (27) bzw. Rastlaschen (26) derart angeordnet sind, das die Rastnasen (27) zum Eingreifen in am Schaltglied (5, 6) vorhandene Vertiefungen (30) und die Rastlaschen (26) zur Aufnahme von am Schaltglied (5, 6) vorhandenen Vorsprüngen (29) ausgebildet sind.

6. Stromzählereinrichtung nach einem der vorangehenden Ansprüche, **dadurch gekennzeichnet, dass** die wenigstens eine Messeinrichtung (3, 4) wenigstens eine Rogowski-Spule (28), die um die wenigstens eine das Gehäuse (22) durchsetzende Ausnehmung (21) herum angeordnet ist, durch die eine Leitung (9) führbar ist und/oder wenigstens eine Hallsonde aufweist.

7. Stromzählereinrichtung nach einem der vorangehenden Ansprüche, **dadurch gekennzeichnet, dass** die wenigstens eine Messeinrichtung (3, 4) zum Erfassen des Stroms und gegebenenfalls des Phasenwinkels als physikalische Größen ausgebildet ist.

8. Stromzählereinrichtung nach einem der vorangehenden Ansprüche, **dadurch gekennzeichnet, dass** die wenigstens eine Messeinrichtung (3, 4) zum Erfassen der physikalischen Größen in festgelegten oder festlegbaren Zeitintervallen ausgebildet ist.

9. Stromzählereinrichtung nach einem der vorangehenden Ansprüche, **dadurch gekennzeichnet, dass** die Zentraleinrichtung (2) zur digitalen Ansteuerung und zum digitalen Auslesen der mindestens einen Messeinrichtung (3, 4) ausgebildet ist, vorzugsweise über einen M-Bus, XML, TCP/IP, LAN oder einen Modbus.

10. Stromzählereinrichtung nach einem der vorangehenden Ansprüche, **dadurch gekennzeichnet, dass** für jede zu messende Leitung (9) eine Zuordnung der gemessenen Leitung (9) zu einer Gruppe und/oder eine Phasenlage entweder an der zugeordneten Messeinrichtung (3, 4) und/oder durch die Zentraleinrichtung (2) einstellbar ist.

11. Stromzählereinrichtung nach einem der vorangehenden Ansprüche, **dadurch gekennzeichnet, dass** die Zentraleinrichtung (2) eine Schnittstelle (19) zur Verbindung mit weiteren Zentraleinrichtungen (2) weiterer Stromzählereinrichtungen (1) aufweist.

12. Stromzählereinrichtung nach einem der vorangehenden Ansprüche, **dadurch gekennzeichnet, dass** der Kommunikationsbaustein (12) mindestens eine Schnittstelle (15, 19) aus der Gruppe M-Bus, Modbus, USB und Ethernet zum Anschluss der Auswerteeinheit aufweist und/oder zur Drahtloskommunikation mit der Auswerteeinheit über WLAN und/oder Bluetooth ausgebildet ist.

13. Stromzählereinrichtung nach einem der vorangehenden Ansprüche, **dadurch gekennzeichnet, dass** der Kommunikationsbaustein (12) einen Webserver (14) aufweist, um die Ausgabedaten der Auswerteeinheit zur Verfügung zu stellen.

14. Stromzählereinrichtung nach Anspruch 13, **dadurch gekennzeichnet, dass** der Webserver mit der Auswerteeinheit über ein Modem, ein DSL-Modem (17, 18), ein GSM-Modem, ein UMTS-Modem oder ein LAN verbindbar oder verbunden ist.

15. Stromzählereinrichtung nach einem der vorangehenden Ansprüche, **dadurch gekennzeichnet, dass** das Gehäuse (22) der Messeinrichtung (3, 4) auf wenigstens einer Seite, vorzugsweise auf zwei insbesondere gegenüberliegenden Seiten, des Gehäuses (22) jeweils ein Kopplungselement (34, 35) zum formschlüssigen Koppeln der Messeinrichtung (3, 4) mit einer weiteren Messeinrichtung (3, 4) aufweist.
